# EUROPÄISCHE PATENTSCHRIFT

(11) **EP 0 931 328 B1**
(45) Veröffentlichungstag und Bekanntmachung des Hinweises auf die Patenterteilung: **22.09.2004**
(21) Anmeldenummer: 97945727.2
(22) Anmeldetag: 08.10.1997
(51) Int. Cl.: H01J 37/30, H01J 37/147, H01J 37/317

(54) **VERFAHREN ZUR STRUKTURIERTEN ENERGIEÜBERTRAGUNG MIT ELEKTRONENSTRAHLEN**
METHOD FOR STRUCTURED ENERGY TRANSMISSION USING ELECTRON BEAMS
PROCEDE DE TRANSMISSION D'ENERGIE STRUCTUREE AVEC DES FAISCEAUX ELECTRONIQUES

(30) Priorität: 12.10.1996 DE 19642116
(43) Veröffentlichungstag der Anmeldung: 28.07.1999
(73) Patentinhaber: F.O.B. GMBH Gesellschaft zur Fertigung Farbiger Optoelektronischer Bauelemente, 06184 Gröbers (DE)
(72) Erfinder: PANZER, Siegfried, D-01279 Dresden (DE); DÄNHARDT, Jürgen, D-01189 Dresden (DE)
(74) Vertreter: Voigt, Wolf-Rüdiger
(86) Internationale Anmeldenummer: PCT/DE1997/002303
(87) Internationale Veröffentlichungsnummer: WO 1998/016947

(56) Entgegenhaltungen:
- EP-A- 0 508 151
- FR-A- 2 294 489

## Beschreibung

Die Erfindung betrifft ein Verfahren zur strukturierten Energieübertragung, indem auf vorzugsweise ebene Oberflächen von Objekten - wie Teile, Platten oder Bänder aus metallischen, halbleitenden oder dielektrischen Werkstoffen oder deren Kombination - kurzzeitig Energie in begrenzte Oberflächenelemente mit dem Elektronenstrahl übertragen wird. Die nutzbaren Bearbeitungseffekte werden durch die physikalische oder chemische Reaktion der Werkstoffe auf die Energieübertragung mit dem Elektronenstrahl bestimmt. Das bevorzugte Anwendungsgebiet ist die Strukturierung von Oberflächen auf beliebig langen streifenförmigen Objekten mit einer begrenzten Anzahl sich wiederholender, in Spalten und Zeilen matrixartig angeordneter Strukturelemente.

Es ist allgemein bekannt, Elektronenstrahlen in vielfältiger Weise zur Materialbearbeitung bzw. Änderungen der Materialeigenschaften zu nutzen. Zur Erzeugung von Oberflächenstrukturen kommen im wesentlichen Sonden- und Maskenverfahren zur Anwendung.

Die Sondenverfahren sind durch die Verwendung eines fokussierten Elektronenstrahls charakterisiert, der entsprechend den zu erzeugenden Strukturelementen durch an sich bekannte programmierte Strahlablenkung auf dem Objekt einwirkt. Auf die verschiedenen Oberflächenorte innerhalb der Strukturelemente wird dabei zeitlich nacheinander die Energie übertragen. Dieses Verfahren ist außerordentlich flexibel einsetzbar. Es hat jedoch den Nachteil, daß es nicht möglich ist, Strukturelemente zu erzeugen, die in ihrer lateralen Ausdehnung kleiner als der Brennfleckdurchmesser des Elektronenstrahls sind. Es ist häufig auch nicht möglich, an die Homogenität der pro Flächeneinheit innerhalb der Strukturelemente zu übertragenden Energiedichte hohe Anforderungen zu stellen. Die in diesem Fall mögliche Homogenitätsverbesserung durch Reduzierung des Brennfleckdurchmessers über die Veränderung der elektronenoptischen Fokussierungsbedingungen hat die nachteilige Folge, daß sich die nutzbare Strahlablenkamplitude verringert. Die Bearbeitung größerer Flächen erfolgt dann durch zeitaufwendige mechanische Objektverschiebung, z.B. in Step-and-Repeat-Technik Eine Grenze für die Anwendung des Sondenverfahrens besteht insbesondere bei der Struktunerung großer Flächen mit dicht angeordneten kleinen Strukturelementen. Hier kann die technisch begrenzte Strahlablenkgeschwindigkeit des Elektronenstrahls die Bearbeitungsdauer für eine bestimmte Aufgabe bis weit in den Bereich der Unwirtschaftlichkeit des Bearbeitungsverfahrens verlängern. Bei Nutzung thermischer Bearbeitungseffekte ist außerdem mit dem Sondenverfahren häufig die Forderung nach hinreichender Gleichzeitigkeit der Energieübertragung auf das gesamte Strukturelement nicht realisierbar.

Zur strukturierten Energieübertragung nach dem Maskenverfahren kommen aufgabenspezifisch verschiedene Varianten - vor allem in der Elektronenstrahilithographie - zur Anwendung. In der Elektronenstrahllithographie hat die elektronenoptische Abbildung einer die Strukturelemente als Aussparungen vom Elektronenstrahl ausgeleuchteten Schablone eine gewisse Bedeutung erhalten. Es sind auch Kombinationstechniken, gekennzeichnet durch die elektronenoptische Abbildung einer das Strukturelement enthaltenden Schablone und seiner durch zusätzliche Strahlablenkung bestimmten Plazierung auf dem Objekt, bekannt.

Im EP-A-0 508 151 wird ein Verfahren und eine Einrichtung zur elektronenstrahllithographischen Strukturierung von Lackmasken auf Halbleiterwafern beschrieben. Bei diesem Verfahren wird eine als blanking aperture array ausgebildete Schablone bzw. Maske elektronenoptisch 1:500 verkleinert auf das Objekt abgebildet. Die Maske enthält eine zellen- und spaltenförmige angeordnete Vielzahl identischer Aussparungen, denen jeweils eine individuell ansteuerbare elektrostatische Ablenkeinheit zugeordnet ist. Die Maske wird von einem Elektronenstrahl geringer, zeitlich und örtlich konstanter Stromdichte ausgeleuchtet. Die durch die Maskenöffnungen hindurchtretenden Elektronenstrahlen gelangen je nach dem Schaltzustand der zugeordneten elektrostatischen Ablenkeinheit entweder über die Abbildungsoptik auf das Objekt oder werden aus dem Abbildungsstrahlengang ausgeblendet.

Über zusätzliche im elektroenoptischen Abbildungssystem zwischen Maske und Objekt enthaltene Strahlablenkeinheiten erfolgt die Plazierung der Einwirkorte der Elektronenstrahlen auf dem Objekt. Nach Maßgabe der Schaltzustände der den Maskenöffnungen zugeordneten elektrostatischen Ablenkeinheiten werden auf dem Objekt komplexe Bearbeitungsstrukturen erzeugt, wobei jedem Bildelement der Bearbeitungsstruktur ein über die entsprechende Maskenaussparung in den Abbildungsstrahlengang gelangender Elektronenstrahl zugeordnet ist. Die Bearbeitung erfolgt am bewegten Objekt. Das Bearbeitungsfeld der Elektronenstrahlen ist in streifenförmige Zonen unterteilt, deren Längsrichtung mit der Bewegungsrichtung des Objektes zusammenfällt. Die Elektronenstrahlen werden entlang dieser Streifen abgelenkt, wobei benachbarte Streifen in entgegengesetzter Richtung durchlaufen werden. Die Strahlabtenkgeschwindigkeit ist dabei sehr groß gegenüber der Bewegungsgeschwindigkeit des Objektes.

Diese bekannten Masken Verfahren erfahren haben den Nachteil des hohen apparativen Aufwandes und der geringen Werte der kurzzeitig übertragbaren Energiedichte. Sie finden deshalb praktisch nur in der Elektronenstrahllithographie zur Erzeugung von latenten Strukturen im Mikrometer- und Submikrometerbereich Anwendung.

Der Erfindung liegt die Aufgabe zugrunde, ein Verfahren zur strukturierten Energieübertragung mit Elektronenstrahlen auf die Oberfläche eines Objektes zu schaffen, das die Grenzen der bekannten Verfahren überwindet. Dabei soll es möglich sein, Strukturelemente, wie auch kleinste Flächenbereiche, z.B. Pixel, in bestimmter Anordnung auf der Oberfläche definiert mit dem Elektronenstrahl zu beaufschlagen, um in diesem Bereich bestimmte Bearbeitungseffekte zu erzielen. Es soll insbesondere für eine begrenzte Anzahl unterschiedlicher Strukturelemente in regelmäßiger Anordnung eine bestimmte Variabilität der übertragenen Energiedichte zulassen. Nichtthermische und thermische Bearbeitungseffekte sollen bei hoher Produktivität und guter Qualtität erreichbar sein.

Erfindungsgemäß wird die Aufgabe nach den Merkmalen des Patentanspruchs 1 gelöst. Weitere vorteilhafte Ausgestaltungen sind in den Patentansprüchen 2 bis 11 aufgeführt.

Die erfindungsgemäße. Lösung besteht im wesentlichen darin, daß ein Elektronenstrahl in bekannter Weise in einer Richtung - der Oszillationsrichtung - nach einer periodischen Funktion hochfrequent abgelenkt wird und annähernd senkrecht zur Oszillationsrichtung - in Ablenkrichtung - über die Aussparungen einer Maske auf der Oberfläche eines unter der Maske berührungsfrei zu dieser in Oszillationsrichtung geführten Objektes durch Strahlablenkung zur Einwirkung gebracht wird. Die Bewegungsrichtung des Objektes ist parallel zur Oszillationsrichtung. Die Bewegungsgzschwindigkeit des Elektronenstrahls in Ablenkrichtung ist groß gegenüber der Bewegungsgeschwindigkeit des Objektes Die Energieübertragung auf die durch die seitliche Ausdehnung der Durchbrüche in der Maske definierten Oberflächenbereiche des Objektes erfolgt dabei in mehreren Teilbeträgen, die durch die Frequenz der periodischen Ablenkfunktion, die Geschwindigkeit der Strahlablenkung in Ablenkrichtung, den Strahldurchmesser in der Maskenebene und die seitliche Ausdehnung der Maskendurchbrüche bestimmt sind. Besteht eine hohe Anforderung an die Homogenität der Energiedichte, so sind die drei erstgenannten Einflußgrößen in bekannter Weise aufeinander abzustimmen. Meist wird innerhalb zumindest eines Strukturelementes eine konstante Energiedichte benötigt. In diesem Falle ist es zweckmäßig, eine bekannte Dreieckfunktion fur die periodische Strahlablenkung zu verwenden.

Bei der Durchführung thermischer Bearbeitungsprozesse ist es erforderlich, die benötigte Energiedichte innerhalb einer kurzen Zeit zu übertragen, um eine quasiadiabatische Energieübertragung, d.h. ohne wesentliche Wärmeableitung aus dem energieabsorbierenden Matenalvolumen während der Energieübertragungsdauer, zu erreichen. Besonders in diesem Fall wird der Elektronenstrahl in die Maskenebene fokussiert und die periodische Ablenkfunktion so hoch wie technisch möglich, beispielsweise im Bereich 100 - 1000 kHz, gewählt Die Strahlablenkgeschwindigkeit in Ablenkrichtung wird so hoch bemessen, daß die Energieübertragungsdauer, die sich aus dem Verhältnis des Strahldurchmessers in der Maskenebene zur Strahlablenkgeschwindigkeit ergibt, den Anforderungen an eine hinreichend adiabatische Energieübertragung entspricht. Die in diesem Fall technisch kaum noch realisierbare formgetreue Übertragung der periodischen Ablenkfunktion wird in den Umkehrpunkten in ihrer Auswirkung auf den Bearbeitungseffekt dadurch begrenzt, daß die Amplitude um einige Strahldurchmesser größer gewählt wird, als sie der Breite der Aussparungsbereiche in der Maske entspricht.

Erfordert die Objektstrukturierung die Übertragung örtlich relativ geringfügig unterschiedliche Energiedichten, so erfolgt deren angepaßte Wahl zweckmäßig durch entsprechende Wahl der Amplitude der periodischen Ablenkfunktion.

Bei einer matrixartigen Anordnung der Strukturelemente auf dem Objekt ist es zweckmäßig, die beiden Strahlablenkrichtungen etwa senkrecht zueinander entsprechend der Strukturanordnung auf dem Objekt zu wählen.

Sind alle Strukturelemente mit etwa gleicher Energiedichte zu beaufschlagen, so ist es zweckmäßig, die Strahlablenkgeschwindigkeit in Ablenkrichtung über die Maske konstant zu halten. Dagegen kann es bei starker Variation der Energiedichte vorteilhaft sein, die Anpassung durch eine ortsabhängige Ablenkgeschwinkeit in Ablenkrichtung durchzuführen.

Bei thermischen Bearbeitungsprozessen kann die thermische Belastbarkeit der Maske dem Verfahren Grenzen setzen. In diesem Falle ist es vorteilhaft, die Maske aus einem gut wärmeleitenden und temperaturbeständigen Werkstoff herzustellen und unmittelbar angrenzend an den Bereich der Aussparungen eine Wasserkühlung vorzusehen. Die Aussparungen in der Maske sind dabei auf eine Spalte begrenzt. Durch Parallelanordnung mehrerer derartiger Spalten in der Maske, die vom Elektronenstrahl zyklisch nacheinander durchlaufen werden, kann die thermische Belastbarkeit der Maske noch wesentlich erhöht werden. Diese Anordnung der Spalten in der Maske kann auch dann vorteilhaft sein, wenn in Richtung der Spalten dicht nebeneinander liegende Strukturelemente auf dem Objekt mit unterschiedlichen Energiedichten zu beaufschlagen sind.

Für das Erreichen einer hohen Verfahrensproduktivität ist es von Vorteil, das zu bearbeitende Objekt mit konstanter Geschwindigkeit senkrecht zur Ablenkrichtung unter der Maske hinwegzuführen. Hohe Anforderungen an die Rechtwinkligkeit der Bearbeitungsstruktur auf dem Objekt können unter diesen Bedingungen dadurch erreicht werden, daß bei konstanter Strahlablenkgeschwindigkeit in Ablenkrichtung die Maske derart gegenüber der Struktur auf dem Objekt verdreht wird, daß der Laufzeiteffekt durch die endliche Strahlablenkgeschwindigkeit in Ablenkrichtung in seiner Auswirkung auf die Lage der vom Elektronenstrahl beaufschlagten Oberflächenelemente auf dem Objekt eliminiert wird.

Das erfindungsgemäße Verfahren ist besonders vorteilhaft einsetzbar, wenn es um die strukturierte Bearbeitung streifen- oder bandförmiger Objekte geht, deren Breite innerhalb der in Ablenkrichtung realisierbaren Strahlablenkamplitude liegt. Übersteigt die Objektbreite diese Grenzen, so ist es möglich, durch Aneinanderreihen streifenförmiger Teilflächen die Gesamtfläche des Objektes zu beaufschlagen.

Ein vorteilhafter Anwendungsbereich ist die hochproduktive strukturierte Bearbeitung relativ großflächiger Objekte. Im Bereich der nichtthermischen Elektronenstrahlbearbeitung betrifft dies vor allem die strukturierte Eigenschaftsmodifikation von Plasten, die Erzeugung von Farbmustern in mit geeigneten elektronenstrahlsensiblen Farbstoffen gefüllten Materialien.

Im Bereich der thermischen Elektronenstrahlbearbeitung kann das Verfahren zur optischen Strukturierung geeignet sensibilisierter Glasoberflächen zum Erzeugen von Displays ebenso eingesetzt werden wie zur strukturierten Härtung von Metalloberflächen aus härtbaren Werkstoffen oder zur abtragenden Bearbeitung, z. B. von Plasten durch Werkstoffverdampfung.

Der bevorzugte Anwendungsbereich des Verfahrens sind ebene streifen- oder bandförmige Objekte. Es ist aber auch eine Behandlung gekrümmter Oberflächen, wie z.B. zylindrische Objekte, möglich. Dazu ist jedoch gegebenenfalls die Maske der Objektgestalt entsprechend anzupassen.

An einem Ausführungsbeispiel wird die Erfindung näher erläutert.

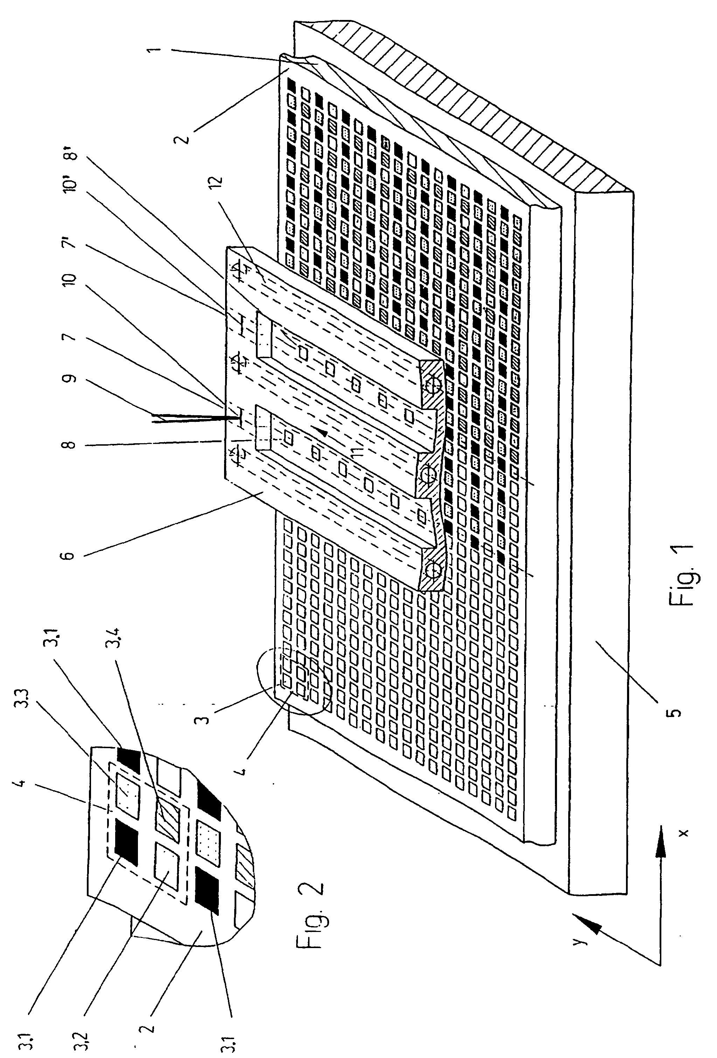

Die zugehörige Zeichnung zeigt in
- Fig. 1:: einen Ausschnitt eines zu behandelnden Objektes mit den dazu erforderlichen Mitteln,
- Fig. 2.: ein Flächenelement in vergrößerter Darstellung (Ausschnitt A).

Ein 10 cm breites streifenförmiges Substrat 1 aus Glas mit einer speziell präparierten dünnen Oberflächenschicht 2 soll in einer aus quadratischen, in einer ortogonalen Matrix angeordneten Pixeln 3 bestehenden Oberflächenstruktur durch Elektronenstrahlbearbeitung strukturiert werden. Dabei bilden je vier Pixel 3 (3 1 bis 3.4) ein Farbelement 4. Um den gewünschten optischen Effekt zu erreichen, sind die vier Pixel 3 mit geringfügig unterschiedlichen Energiedichten zu beaufschlagen. Bei dem Bearbeitungseffekt handelt es sich um einen thermischen Effekt, der es erfordert, daß die dünne präparierte Oberflächenschicht 2 in den Bereichen der Pixel 3 zeitgleiche, in der Maximaltemperatur aber geringfügig unterschiedliche Temperaturzyklen durchläuft, um pixelweise bestimmte optische Eigenschaften zu erhalten.

### Das erfindungsgemäße Verfahren wird wie folgt ausgeübt:

Das Substrat 1 wird auf einem üblichen, in x-Richtung beweglichen Tisch 5 aufgenommen. Der Tisch 5 wird in x-Richtung mit konstanter Geschwindigkeit bewegt. Mit dem nicht dargestellten Tischantrieb ist ein bekanntes Meßsystem verbunden, über das die exakte momentane Bewegungskoordinate in x-Richtung angegeben wird. Direkt über dem Substrat 1, aber berührungsfrei zu diesem, befindet sich ortsfest die Maske 6 (nur z.T. dargestellt). Diese enthält längs der Spalten 7 und 7' die Aussparungen 8; 8', über die der Elektronenstrahl 9 in den Pixeln 3 auf dem Substrat 1 zur Einwirkung gebracht wird. Die Pixel 3 je Farbelement 4 werden mit geringfügig unterschiedlichen Energiedichten beaufschlagt. Der Elektronenstrahl 9 mit seinen entsprechend stabilisierten Parametern Beschleunigungsspannung, Strahlstrom und seinem Strahldurchmesser in der Ebene der Maske 6 trifft zunächst auf einen intensiv gekühlten Bereich der Maske 6 außerhalb der Aussparungen 8. Der Elektronenstrahl 9 wird in Richtung des Pfeiles 10 (Oszillationsrichtung) parallel zur x-Richtung oszillierend symmetrisch zur Achse der Spalten 7; 7' nach einer periodischen Dreieckfunktion mit 200 kHz abgelenkt. Die Ablenkamplitude ist etwa fünf Strahldurchmesser größer als die Ausdehnung der Pixel 3 gewählt. Dadurch wird der Einfluß der endlichen Grenzfrequenz auf die Homogenität der auf das Substrat 1 übertragenen Energiedichte hinreichend eliminiert. Die Beschleunigungsspannung, der Strahlstrom, die Amplitude der periodischen Ablenkung und die vorgewählte Ablenkgeschwindigkeit in Ablenkrichtung sind derart aufeinander abgestimmt, daß in den Pixeln 3 die erforderliche Energiedichte übertragen werden kann. Erreicht Pixel 3.1 Deckungsgleichheit mit der obersten Aussparung 8 in Spalte 7 der Maske 6, so wird der Elektronenstrahl 9 mit der entsprechenden Geschwindkeit in y-Richtung über die volle Substratbreite geführt. Die Rückführung des Elektronenstrahls 9 erfolgt über den gekühlten Bereich der Maske 6 entlang der Richtung des Pfeiles 11 in die zweite Ausgangsposition entsprechend Pfeil 10'. Hier erfolgt zunächst die Anpassung der Amplitude der periodischen Ablenkfunktion an den für die erforderliche Energiedichte benotigten Wert. Erreichen nun die nächsten Pixel 3.2 Deckungsgleichheit mit der nächsten Aussparung 8' in Spalte 7' der Maske 6, so wird der Elektronenstrahl 9 mit der gleichen Ablenkgeschwindigkeit wie vorher über die Spalte 7' der Aussparungen 8' der Maske 6 geführt, Die Strahlrückführung auf der Maske 6 erfolgt auf dem gleichen Weg gemäß dem Pfeil 11 zurück in die Position von Pfeil 10. Nun erfolgt nach vorausgegangener Amplitudenanpassung der periodischen Ablenkfunktion in analoger Weise die Energieübertragung und damit die Bearbeitung der nächsten Pixel 3.3 und 3.4. Zur paßgerechten Positionierung der Pixel 3 auf dem Substrat 1 sind der x-Abstand der Achsen der Spalten 7; 7', die Laufdauer des Elektronenstrahls 9 über die Substratbreite und die Einstellzeiten für die unterschiedlichen Amplituden der periodischen Ablenkung des Elektronenstrahls 9 geeignet aufeinander abgestimmt.
Im Verfahrensablauf werden auf der gesamten Oberfläche des Objekts 1 matrixartig verteilt Farbelemente 4 erzeugt. Diese Farbelemente 4 bestehen aus je vier Pixeln 3. Durch die beschriebenen Verfahrensschritte werden nacheinander auf einer Reihe in schneller Folge die Pixel 3.1 - 3.2 - 3.3 - 3.4 unter den Aussparungen 8 bzw. 8' der Maske 6 vom Elektronenstrahl 9 beaufschlagt. Durch den bei jedem Durchlauf des Elektronenstrahls 9 wechselnden, d.h. dem gewünschten Ergebnis angepaßten Energieeintrag des Elektronenstrahls 9 werden für jedes Pixel 3 eines Farbelementes 4 unterschiedliche optische Eigenschaften erreicht
Die für das beschriebene Verfahren erforderliche Energiedichte beträgt mehrere Ws/cm². Mit einem Elektronenstrahl 9 von einigen kW Strahlleistung ergibt sich eine typische Ablenkgeschwindigkeit > 20 m/s. Bei 10 cm Substratbreite beträgt die Laufzeit des Elektronenstrahls 9 über das Substrat etwa 5 ms. Für die Strahlrückführung und Amplitudenanpassung werden weitere maximal 5 ms benötigt. Damit ergeben sich 10 ms als Bearbeitungszeit einer Spalte von Strukturelementen. Das bedeutet, daß pro Sekunde 100 Spalten bearbeitet werden können. Bei einer x-Distanz der Spalten 7; 7' der Pixel 3 von 0,2 mm beträgt die benotigte Geschwindigkeit der Tischverschiebung 2 cm/s. Die sekundlich strukturierte Oberfläche beträgt dann 20 cm². Das Verhältnis von Tischgeschwindigkeit zur Ablenkgeschwindigkeit des Elektronenstrahls 9 von 1 zu 1000 ergibt eine entsprechende Abweichung von der Ortogonalität zwischen den Reihen und Spalten des Pixel 3. Sofern diese Abweichung storend ist, kann sie durch eine entsprechende Verdrehung der Maske 6 entgegen dem Uhrzeigersinn eliminiert werden.
Die relativ hohe thermische Belastung der Maske 6 macht eine intensive Kühlung derselben erforderlich. Dies erfolgt durch die wasserdurchflossenen Kühlkanäle 12 in der Maske 6.

## Patentansprüche

1. Verfahren zur strukturierten Energieübertragung mit Elektronenstrahlen auf ein Objekt mittels eines fokussierbaren, zweidimensional ablenkbaren Elektronenstrahls, in dem das Objekt unmittelbar unter einer Maske berührungsfrei zu dieser bewegt wird, wobei der Elektronenstrahl parallel zur Bewegungsrichtung des Objektes hochfrequent oszilierend etwa senkrecht zur Bewegungsrichtung des Objektes über die in der Maske befindlichen Aussparungen geführt wird und die Geschwindigkeit der Strahlführung sehr groß gegenüber der Geschwindigkeit der Objektbewegung ist.

2. Verfahren nach Anspruch 1, **dadurch gekennzeichnet, daß** für die Ablenkung des Elektronenstrahls in Richtung der Oszillation eine Dreiecksfunktion gewählt wird.

3. Verfahren nach Anspruch 1, **dadurch gekennzeichnet, daß** die Frequenz der periodischen Ablenkfunktion - bezogen auf die Geschwindigkeit der Strahlablenkung in der Bewegungsrichtung des Objektes - so hoch gewählt wird, daß die überlagerten Energiebeiträge auf dem Objekt den gestellten Homogenitätsanforderungen entsprechen.

4. Verfahren nach Anspruch 1 bis 3, **dadurch gekennzeichnet, daß** die Amplitude der periodischen Ablenkfunktion größer als die in Richtung der Oszillation liegende Ausdehnung der Aussparungen in der Maske gewählt wird.

5. Verfahren nach Anspruch 1 bis 4, **dadurch gekennzeichnet, daß** die zu übertragende Energiedichte bei konstantem Strahlstrom durch Veränderung der Amplitude der periodischen Ablenkfunktion angepaßt wird.

6. Verfahren nach Anspruch 1 bis 5, **dadurch gekennzeichnet, daß** die Geschwindigkeit für die Ablenkung des Elektronenstrahls in senkrecher Richtung zu seiner Oszillation über den gesamten Bereich der Aussparungen in der Maske konstant gehalten wird.

7. Verfahren nach Anspruch 1 bis 6, **dadurch gekennzeichnet, daß** die Ablenkgeschwindigkeit des Elektronenstrahls in rechtwinkliger Richtung zur Objektbewegungsrichtung so hoch gewählt wird, daß die Energieübertragung auf die zu beaufschlagenden Strukturelemente quasi ohne wesentliche Wärmeableitung aus dem energieabsorbierenden Materialvolumen während der Energieübertragungsdauer erfolgt.

8. Verfahren nach Anspruch 1 bis 7, **dadurch gekennzeichnet, daß** zur örtlichen Variation der auf das Objekt zu übertragenden Energiedichte der Elektronenstrahl ortsabhängig mit variabler Geschwindigkeit abgelenkt wird.

9. Verfahren nach Anspruch 1 bis 8, **dadurch gekennzeichnet, daß** die Maske gekühlt wird

10. Verfahren nach Anspruch 1 bis 9, **dadurch gekennzeichnet, daß** das zu behandelnde Objekt mit konstanter Geschwindigkeit unter der Maske bewegt wird.

11. Verfahren nach Anspruch 1 bis 10, **dadurch gekennzeichnet, daß** nach Maßgabe der Strahlablenkgeschwindigkeit senkrecht zur Oszillationsrichtung und der Bewegungsgeschwindigkeit des Objektes die Maske zur y-Richtung derart gedreht wird, daß der Laufzeiteffekt des Elektronenstrahls über die Maske bezüglich der Koordinatenlage der beaufschlagten Oberflächenelemente auf dem Objekt eliminiert wird.

## Claims

1. Method for structured energy transmission using electron beams onto an object by means of a focusable electron beam deflectable in two planes, where the object is moved directly underneath a mask contactless to the latter, and the electron beam that high-frequently oscillates parallel to the object's moving direction travels over the openings in the mask approximately nearly crosswise to the object's moving direction, the beam as such travelling at a speed much higher compared with the rate at which the object is moved.

2. Method according to claim 1 **characterized in that** a triangle function is selected to control the electron beam's deflection in oscillating direction.

3. Method according to claim 1 **characterized in that** the frequency of the periodical deflection function, in relation to the speed at which the beam is deflected in the object's moving direction, is high enough to meet the homogeneity requirements as regards the overlapping energy contributions onto the object.

4. Method according to claims 1 to 3 **characterized in that** the selected amplitude of the periodical deflection function is greater than the distance over which the openings in the mask are spread, seen in oscillation direction.

5. Method according to claims 1 to 4 **characterized in that** the density of the energy to be transmitted at constant beam current is adjusted by changing the amplitude of the periodical deflection function.

6. Method according to claims 1 to 5 **characterized in that** the speed at which the electron beam, travelling over the entire field of openings in the mask, is deflected crosswise to its oscillating direction is kept at a constant value.

7. Method according to claims 1 to 6 **characterized in that** the speed at which the electron beam is deflected at right angles to the object's moving direction is adjusted to such a high value as to ensuring that the energy transmission impinging upon the structural elements occurs virtually without significant heat dissipation from the materials volume that is absorbing such energy during the period of time over which the energy is transmitted.

8. Method according to claims 1 to 7 **characterized in that** a variable deflection at a variable speed of the electron beam is used to vary, in certain locations, the electron density to be transmitted onto that location.

9. Method according to claims 1 to 8 **characterized in that** the mask is cooled.

10. Method according to claims 1 to 9 **characterized in that** the object to be treated is moved underneath a mask at constant speed.

11. Method according to claims 1 to 10 **characterized in that** depending on the speed of the beam deflection crosswise to the oscillation direction and the object's moving speed the mask is turned into y-axis direction so as to eliminating transit time effects when the electron beam travels over the mask in relation to the actual place, defined by its coordinates, of the object's individual surface element impinged.

## Revendications

1. Procédé de transmission d'énergie structurée avec des faisceaux électroniques sur un objet au moyen d'un faisceau électronique focalisable pouvant être bidimensionnellement défléchi, selon lequel l'objet est déplacé directement sous un masque sans le toucher, le faisceau électronique étant guidé parallèlement au sens de déplacement de l'objet en oscillant à haute fréquence à peu près verticalement envers le sens de déplacement de l'objet au dessus des creux se trouvant dans le masque et la vitesse de guidage du faisceau étant très grande par rapport à la vitesse de déplacement de l'objet.

2. Procédé selon revendication 1, **Caractérisé par le fait que** pour la déflexion du faisceau électronique dans le sens de l'oscillation une fonction triangulaire sera choisie.

3. Procédé selon revendication 1, **Caractérisé par le fait que** la fréquence de la fonction de déflexion périodique - rapportée à la vitesse de déflexion du faisceau dans le sens de déplacement de l'objet - est choisie à une telle valeur que le gisement énergétique superposé sur l'objet corresponde aux exigences d'homogénéité posées.

4. Procédé selon revendications de 1 à 3, **Caractérisé par le fait que** l'amplitude de la fonction de déflexion périodique est choisie plus grande que l'extension des creux dans le masque se trouvant dans le sens de l'oscillation.

5. Procédé selon revendications de 1 à 4, **Caractérisé par le fait que** la densité de l'énergie à transmettre sous un courant de faisceau constant est adaptée à la fonction de déflexion périodique par modification de l'amplitude.

6. Procédé selon revendications de 1 à 5, **Caractérisé par le fait que** la vitesse pour déflexion du faisceau électronique est maintenue cons tante dans le sens perpendiculaire envers son oscillation sur le domaine complet des creux dans le masque.

7. Procédé selon revendications de 1 à 6, **Caractérisé par le fait que** la vitesse de déflexion du faisceau électronique dans le sens perpendiculaire envers le sens de déplacement de l'objet est choisie de manière aussi élevée que la transmission d'énergie a lieu sur les éléments de structure à alimenter pour ainsi dire sans dissipation importante de chaleur sortant du volume de matière absorbant l'énergie pendant la durée de la transmission d'énergie.

8. Procédé selon revendications de 1 à 7, **Caractérisé par le fait que** par rapport à la variation locale de la densité d'énergie à transmettre sur l'objet le faisceau électronique est défléchi avec une vitesse variable en fonction du lieu.

9. Procédé selon revendications de 1 à 8, **Caractérisé par le fait que** le masque est refroidi.

10. Procédé selon revendications de 1 à 9, **Caractérisé par le fait que** l'objet à traiter est déplacé à vitesse constante sous le masque.

11. Procédé selon revendications de 1 à 10, **Caractérisé par le fait qu'en** considération de la vitesse de déflexion du faisceau perpendiculaire à la direction de l'oscillation et de la vitesse de déplacement de l'objet le masque sera tourné de telle manière dans le sens vertical que l'effet de la durée de marche du faisceau électronique au-dessus du masque est éliminé par rapport à la position des coordonnées des éléments superficiels concernés sur l'objet.
